(19) Europäisches Patentamt
European Patent Office
Office européen des brevets

(11) Publication number: 0 048 315 B1

(12) **EUROPEAN PATENT SPECIFICATION**

(45) Date of publication of patent specification: **10.04.85**

(51) Int. Cl.[4]: **B 32 B 27/34**, C 09 J 3/00, B 32 B 15/08, B 32 B 31/20

(21) Application number: **81103464.4**

(22) Date of filing: **07.05.81**

(54) **Process for preparing high temperature polyimide film laminates.**

(30) Priority: **22.09.80 US 189234**

(43) Date of publication of application: **31.03.82 Bulletin 82/13**

(45) Publication of the grant of the patent: **10.04.85 Bulletin 85/15**

(84) Designated Contracting States: **BE DE FR GB IT NL SE**

(56) References cited:
GB-A-1 343 851
US-A-3 449 193
US-A-3 620 907
US-A-3 740 305
US-A-3 770 573
US-A-4 183 839

(73) Proprietor: **NATIONAL AERONAUTICS AND SPACE ADMINISTRATION**
**NASA Headquarters**
**Washington, D.C. 20546 (US)**

(72) Inventor: **St. Clair, Anne King**
**17 Roberts Landing Drive**
**Poquoson Virginia (US)**
Inventor: **St. Clair, Terry Lee**
**17 Roberts Landing Drive**
**Poquoson Virginia (US)**

(74) Representative: **Hansen, Bernd, Dr.rer.nat. et al**
**Hoffmann, Eitle & Partner Patentanwälte**
**Arabellastrasse 4**
**D-8000 München 81 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

Flexible electrical circuits are presently being used commercially in computers, cameras, telephone and PBX systems, medical equipment controls and in automobile radios. These reliable interconnection devices save space and assembly time and it is anticipated that additional uses in aerospace and other applications will be forthcoming now that electronic designers no longer regard flexible circuits as experimental but accept such circuitry as reliable. One problem that has limited their use is the ability of present flexible circuits to remain reliable under extreme temperature variations. This unreliability is believed partially due to the presence of voids created in the flexible circuits during bonding because of volatiles in the adhesives and also because of the inherent rigidity of some adhesives. There is a definite need in the aerospace industry for reliable flexible electrical circuitry for temperature and pressure variable applications on missiles; aircraft and spacecraft.

Linear aromatic polyimides are excellent candidates for such applications because they are thermally stable at temperatures between 477K and 589K, flexible, and light in weight. Thus, a process for laminating large areas of void-free high temperature polyimide film is needed for aerospace applications.

A problem exists, however, in using a linear aromatic polyimide adhesive to bond polyimide film to itself or to metal surfaces, such as is desired for various circuitry applications, due to the evolution of unwanted volatiles. Such volatiles can be the result of condensation reaction by-products and/or excess solvent, both of which cause difficulties in the preparation of large-area, void-free laminates.

Several years ago, a particular need for a flexible, high temperature adhesive to bond ultrathin polyimide film was presented by the proposed NASA Solar Sail Program. A flexible adhesive was needed for joining strips of 0.002 µm the polyimide Kapton® H film at intervals across each sail blade measuring 8 meters in width by 7350 meters in length. Kapton® is available in various thicknesses and is a trademark of the DuPont Company for a linear polyimine film formed from pyromellitic dianhydride (PMDA) and 4,4'-oxydianiline (ODA). Several linear polyimide adhesives were developed for this application using the following monomers:

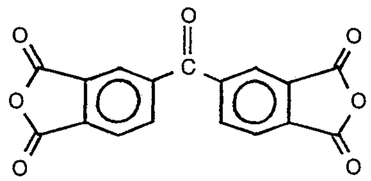

BTDA

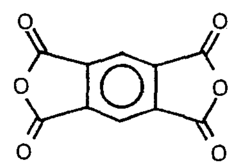

PMDA

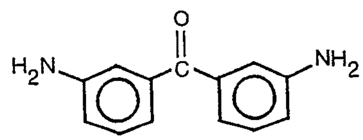

DABP

The adhesives indentified as LARC—2, 3, and 4 and formulates as shown in Table I, were prepared in a nontoxic ether solvent and proved successful in bonding 0,64 cm overlaps of thin polyimide Kapton film. The adhesives themselves showed good thermal stability when subjected to temperatures of 575K in excess of 500 hours and the adhesive bonds also showed excellent retention of strength after aging 6000 hours at elevated temperature. Although these 0.64 cm polyimide bonds were not entirely "void-free", the adhesives were far stronger than the films they joined. A more complete description of these adhesives is found in the January 1979 issue of *Adhesive Age*, pages 35—39, which is incorporated herein by reference.

TABLE I

Kapton Adhesives

| Resin | Formulation | Amic Acid ηinh | $T_g$ K |
|---|---|---|---|
| LARC—2 | BTDA<br>3,3'-DABP | 0.70 | 520 |
| LARC—3 | 2 BTDA/1 PMDA<br>3,3'-DABP | 0.63 | 542 |
| LARC—4 | 3 BTDA/1 PMDA<br>4,4'-DABP | 0.50 | 570 |

The 0,64 cm overlap of the polyimide bonds described above is small enough in area to provide escape for a large portion of volatiles. The difficulty arises in bonding larger areas. A definite need still exists for a method for joining larger areas of polyimide film, so as to produce 100% void-free laminates.

In US—A—3 740 305 a process for laminating polyimide films is disclosed in which a bonding is

achieved in a conventional way by siloxane/polyamic acid, wherein condensation byproducts and solvents are given off during the cure to a siloxane containing polyimide. This system is not a polyiimide system. The amic acid proportion of the siloxane containing polyamic acid block copolymer is heated under pressure after being applied to the substrates at a temperature of about 100°C for 1 to 4 hours to remove most of the volatile while the coating remains uncured.

In US—A—4 183 839 a method of preparing polyimides by exchange reaction of a bisimide containing oxoimine with an aromatic diamine to produce an aromatic polyimide with an aliphatic amino acid byproduct is disclosed. This aromatic/aliphatic (low temperature) system is used for spray and dip coatings and adhesives, but the aliphatic-free amine degrades the polymer on any long-term aging at elevated temperatures. At high temperatures the amino acid byproducts can exchange again with an amine causing further degradation. Most polyiimides cure with evolution of volatiles (solvent and condensation byproducts) which cause voids and blistering when subjected to elevated temperatures. The process of US—A—4 183 839 eliminates the problem of condensation byproducts by using a bisimide but sacrificed long-term temperature stability by the aliphatic amine byproduct being released instead of the usual condensation byproducts. This prior art teaching still has the problem of excess solvent which can cause blistering when the polyimide is aged under elevated temperature conditions.

US—A—3 449 193 is directed to bonding of poly(imide-amide) films wherein the adhesive is applied to the film and (1) heated to a high temperature for partial solvent removal initially, (2) the adhesive coating film is wrapped about a heated roll for a time, (3) passed through a nip to cause a bond to be formed between the film and the adhesive and (4) subsequently heated to the ultimate temperatures and cured slowly in multiple zones to prevent bubbling and delamination due to the solvent being removed during this curing series. In this polyimide amid process, multiple process steps are required to produce more than one layer due to required solvent removal during cure and the resulting structure remains less thermally stable than our all aromatic polyimide system.

Void-free laminates of thin polyimide film are deemed useful in high temperature packaging or encapsulating for the purpose of environmental protection. The "through-the-thickness" (ITT) strength of thick commercial polyimide film, Kapton for example, is very poor and prohibits the use thereof in certain applications. However, by use of the present invention, thick laminates of the commercially thin film can be produced without decreasing the individual layer (TTT) strength and thereby yield a thick polyimide laminate having improved physical property characteristics. It is also anticipated that polyimide film and laminates thereof constructed according to the present invention will prove useful as coatings wherein the polyimide film is primed with an adhesive, the adhesive B-staged and the film bonded to different substrates to serve as a protective high temperature resistant coating thereon.

It is an object of the present invention to provide an improved process for laminating high temperature resistant polyimide film.

Another object of the present invention is a method for preparing flexible, large-area, 100% void-free laminates from polyimide film.

A further object of the present invention is an improved method for laminating polyimide film to itself and to metal surfaces for ultimate flexible circuit applications.

An additional object of the present invention is the use of a thermoplastic bonding laminating process free of solvent and void-free to recover high temperature resistant polyimide laminate structures.

According to the present invention the foregoing and additional objects are obtained by providing at least two layers of thin polyimide film; providing at least one layer of polyimide adhesive on one of said at least two layers of polyimide film; assembling said two layers of polyimide film to form a sandwich and subjecting the film-adhesive sandwich to heat and pressure to thermoplastically bond the sandwich into a void-free laminate structure, wherein said polyimide adhesive layer is a solvent free polyamic acid that is B-staged to the polyimide state prior to assembling of the polyimide film sandwich.

Fig. 1 is a graphic illustration of the thermal stability of the adhesives employed in the present invention;

Fig. 2 is a graphic illustration of the adhesive strength exhibited by the adhesive bonds of the present invention when exposed to elevated temperatures;

Fig. 3 is a schematic illustration of the liquid adhesive applied to one sheet of a pair of polyimide film sections to be bonded according to the present invention;

Fig. 4 is a view similar to Fig. 3 illustrating the use of a B-staged adhesive film as the bonding agent between two sheets of polyimide film;

Fig. 5a is a schematic illustration of a metal layer positioned between two sheets of adhesive coated polyimide films prior to pressure molding thereof to encase the metal film;

Fig. 5b is an illustration similar to Fig. 5a illustrating the use of B-staged polyimide adhesive film as the adhesive agent;

Fig. 6 is a schematic illustration of the mold assembly for laminating two layers of polyimide film according to the present invention; and

Fig. 7 is a schematic illustration of multiple layers of polyimide film in position for laminating according to the present invention.

*Detailed Description*

Referring now to the drawings, Fig. 1 shows a graphic illustration of the excellent thermal stability properties of the various adhesives employed in the present invention when subjected to temperatures of 575K for an excess of 500 hours. Fig. 2 shows a graphic illustration of the retention of strength for the various adhesives after 6000 hours exposure at elevated temperature.

One process for producing large area polyimide film laminates according to the present invention involves the following steps: (1) the polyimide film to be laminated is primed with a thin coat of a linear polyamic acid adhesive solution; (2) the primed polyimide film is then B-staged by preheating to 493K in air for one hour to remove excess solvent and convert the polyamic acid adhesive to the more stable polyimide; (3) the B-staged film is then thermoplastically bonded to another sheet of primed film or unprimed film, as shown in Fig. 3, in a steel mold (Fig. 6) at 616K for five minutes under a pressure of 3,5 to 21 bar; and (4) the polyimide film laminate is cooled under pressure before removing from the mold. The resulting laminate is clear yellow, extremely flexible, and 100% void-free. It cannot be peeled and attempts at peeling the laminate cause failure to occur in the film itself.

A second process for producing large area polyimide film laminates according to the present invention involves the following steps: (1) a thin film of the polyamic acid adhesive is fabricated by casting the solution on a flat surface; (2) the polyamic acid adhesive film is thermally imidized to the polyimide by heating in air to 493K for one hour; (3) the adhesive film is then stripped from the casting surface and placed between two sheets of polyimide film to be laminated, as shown in Fig. 4; (4) the sandwich prepared as in step 3 is placed in a steel mold (Fig. 6) and thermoplastically laminated at 616K for five minutes under a pressure of 3,5 to 21 bar; and (5) the polyimide lamiante is cooled under pressure.

Successful laminates prepared by the processes described in the present invention were made from polyimide film using the following film thicknesses: 0.013 mm, 0.025 mm, 0.076 mm, and 0.127 mm. However, other film thicknesses should also produce good laminates. The film was cleaned prior to bonding with a cloth containing ethanol. Any other solvent useful in removing dust particles, fingerprints, etc., should be acceptable in preparing the film for lamination. Although DuPont's Kapton® H film was used to produce the polyimide film laminates described in most of the Examples herein, other linear aromatic polyimide films may also be used for lamination by the process of the present invention.

For example, polyimide film which may be employed in the lamination process of the present invention are selected from the group of polyimides having the following structure:

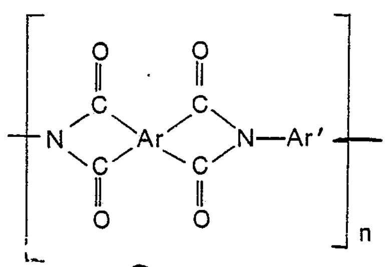

where Ar is either of 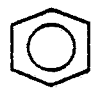, or 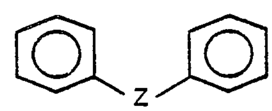

where Z is selected from –O–, $-\overset{\overset{O}{\|}}{C}-$, $-C(CF_3)_2-$, –S–, $SO_2-$,

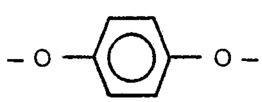, 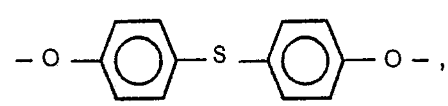, and

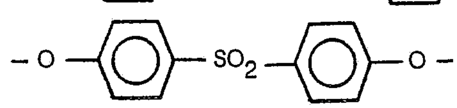; and Ar′ is either of

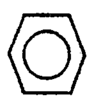, or 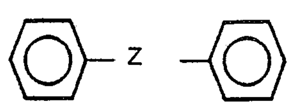 where Z′ is selected from

–O–, $-\overset{\overset{O}{\|}}{C}-$, –S–, $-SO_2-$, $-CH_2-$, $-C(CH_3)_2-$, and –CHOH–.

The thermoplastic polyimide adhesives used for fabricating the laminates described in the present invention were prepared using the linear aromatic LARC polyamic acid solutions in Table I. The LARC—2, 3, and 4 solutions were used at a concentration of 15% solids in N,N-dimethylacetamide (DMAc) or bis(2-methoxyethyl)ether (diglyme). Other useful solvents may include amide-type solvents such as N,N-dimethylformamide, N-methyl-2-pyrrolidone, and dimethylsulfoxide or ether-type solvents such as tetrahydrofuran, m- and p-dioxane, and 1,2-bis(methoxyethoxy)ethane.

The B-stage step should be varied depending upon the adhesive and solvent used. When DMAc was used as a solvent for the adhesive, B-staging was achieved by heating the adhesive film or polyimide film coated with adhesive directly in air to 493K and holding at temperature for one hour. However, when diglyme was used as the adhesive solvent, it was necessary to carry out the B-stage more slowly so as not to foam the adhesive. The B-stage for diglyme-containing adhesives consisted of heating in air $\frac{1}{2}$ hour at 373K, one hour at 453K, and one hour at 493°K. Ultimate sucess in obtaining a void-free laminate depends on the B-stage step for complete removal of excess solvent and the thermal conversion of the adhesive polyamic acid to the polyimide prior to laminating.

Although the LARC polyamic acids were used as adhesives for the specific example illustrations of the present invention, other linear aromatic polyamic acids/polyimides may be employed as long as they are B-staged correctly to ensure solvent removal and imidization. Also, a candidate adhesive solution for the lamination process described herein must produce a polyimide with a glass transition temperature (or softening temperature) low enough so as to remain processable during the lamination.

Although 616K was specified as the lamination temperature in the above processes, longer time at a lower temperature or shorter time at a higher temperature could also be used to prepare a laminate of the same quality. When a laminating temperature of 644K was used for five minutes, the resulting laminate was very dark indicating that decomposition of the polymers had begun to occur. Best results were obtained when the press was preheated to 505K before inserting the laminate mold. The temperature of the press platens was then raised directly to 616K and held for five minutes. The platens were air-cooled to within 373K before opening.

Successful lamination of the polyimide film occurred using pressures of 3,5 bar, 10,5 bar, and 31 bar. Lower pressures might be used if pressure were applied evenly. Pressures as high as 70 bar were attempted, but with no visible improvement in the quality of the resulting laminate. For best results, the pressure was applied as soon as the laminate mold was placed between the preheated platen; and that same pressure was maintained until after the platens had cooled. Bumping (release of pressure followed by reapplying the same pressure) was attempted on several of the laminates after the maximum temperature was reached. The bumping technique often used to allow the escape of excess volatiles proved to be unnecessary in the preparation of 100% void-free laminates and was discarded. The ultimate success in achieving a well consolidated polyimide laminate was found to be dependent upon attaining an even distribution of pressure. The use of several layers of woven glass fabric (Fig. 6) between the polyimide film laminate and the steel mold served to evenly distribute the pressure on the laminate. The laminating process was also carried out with a vacuum bag surrounding the laminate mold, but evacuating the system did not produce better laminates.

The above described processes for laminating polyimide film are also used to prepare metal-containing laminates for use as flexible circuits and the like. The first process may be adapted by placing a conductive metal sheet or foil between two sheets of polyimide film that has been primed with adhesive and B-staged as shown in Fig. 5a. The second described process may be modified by placing a sheet of B-staged adhesive film and polyimide film to be laminated on both sides of the metal forming a sandwich as shown in Fig. 5b. Although aluminum, brass, copper and stainless steel have been successfully laminated to polyimide film using this process, other metals or metal-coated film may be employed and are considered within the scope of this invention. The metals need only to be degreased with a solvent such as ethanol or methylethylketone prior to laminating, although a more strenuous surface preparation may be used when desired. Suitable flexible electrical circuits are cut or stamped from the polyimide-metal laminates.

Polyimide film laminates have been prepared using the above described processes that vary in size from 77.4 $cm^2$ to 645 $cm^2$. Larger area laminates can be made using the present processes as long as the entire area of lamination receives even temperature and pressure. The thickness of the laminate may also be varied. An 8-ply polyimide film laminate (Fig. 7) was successfully prepared that was 100% void-free and flexible. Thicker laminates can be fabricated as long as the temperature and pressure demands are met.

*Specific Examples*

Example 1

A 7.6 cm × 10.2 cm polyimide film laminate was prepared from 0.076 mm Kapton® H film using LARC—2 (Table I) polyamic acid in diglyme as an adhesive. The Kapton® film was brush-coated at room temperature with the LARC—2 adhesive solution and placed in a low humidity environment (approximately 20%) for fifteen minutes. The Kapton® film primed with adhesive as then B-staged in a forced air oven for 1/2 hour at 373K, one hour at 453K (356°F), and one hour at 493K. The primed and B-staged film was cooled to within 373K (212°F) before removing from the oven. At this stage the adhesive coating was free of excess solvent, thermally imidized, and measured approximately 0.013 mm in thickness.

The laminate was then assembled as shown in Fig. 6 in a steel mold previously sprayed with a suitable release agent, and inserted between press platens preheated to 505K. A pressure of 21 bar was applied and maintained. The mold was heated directly to 616K and the temperature held for five minutes. The laminate was cooled under pressure to 373K.

The resulting laminate was clear yellow, entirely flexible, and 100% void-free. Peeling was attempted but failure occurred first in the polyimide film.

Example 2

A 7.6 cm × 10.9 cm polyimide film laminate was prepared from 0.025 mm Kapton® film using LARC—2 adhesive in DMAc. An adhesive film was prepared by casting a 15% DMAc solution of LARC—2 onto a glass plate and B-staging in a forced air oven at 493K for one hour. The oven was cooled to within 373K before removing the glass plate. The plate was then immersed under tap water and the 0.025 mm thick adhesive film was removed from the plate and dried. The adhesive film was sandwiched between two sheets of Kapton® film (Fig. 4) with two layers of cloth on each side of the laminate and placed in a steel mold as illustrated in Fig. 6. The laminating process and results were the same as for Example 1.

Example 3

A Kapton® laminate was successfully prepared as in Example 1 using LARC—3 in diglyme as the adhesive solution.

Example 4

A Kapton® laminate was prepared as in Example 1 combining a sheet of umprimed Kapton® with a sheet of adhesive-primed Kapton®. Coating only one of the Kapton® sheets with adhesive made no difference in the resulting laminate, which was flexible and void-free.

Example 5

A large area, 25.4 cm × 25.4 cm, Kapton® laminate was successfully prepared as in Example 1.

Example 6

A Kapton® laminate was successfully prepared as in Example 1 using a pressure of 3,5 bar throughout the lamination.

Example 7

A Kapton® laminate was successfully prepared as in Example 1 using 0.013 mm Kapton®.

Example 8

A Kapton® laminate was successfully prepared as in Example 1 using 0.127 mm.

Example 9

A Kapton® laminate comprised of eight plies was successfully prepared as in Example 1. The eight plies were assembled as shown in Fig. 7.

Example 10

A Kapton®/aluminum/Kapton® laminate was successfully prepared as in Example 1. The laminate was assembled according to the diagram in Fig. 5a using thin commercial aluminum foil as the metal.

Example 11

A Kapton®/brass/Kapton® laminate was successfully prepared as in Example 10.

Example 12

A Kapton®/copper/Kapton® laminate was successfully prepared as in Example 10.

Example 13

A Kapton®/stainless steel/Kapton® laminate was successfully prepared as in Example 10.

Example 14

A 7.6 cm × 10.2 cm polyimide film laminate was prepared using 0.025 mm BTDA + ODA polyimide film with LARC—2 polyamic acid in diglyme as an adhesive.

The BTDA + ODA polyimide film to be laminated was prepared by reacting a 1:1 stoichiometric ratio of 4,4'-benzophenone tetracarboxylic dianhydride (BTDA) and 4,4'-oxydianiline (ODA) in DMAc at 15% solids by weight. The resulting high molecular weight polyamic acid which gave an inherent viscosity of 1.14 was cast onto a glass plate and heated in a forced air oven one hour at 300°C.The polyimide (BTDA + ODA) film which was formed on curing was removed from the plate and used as an adherend for the LARC—2 adhesive.

LARC—2 adhesive was brush-coated onto the BTDA + ODA polyimide film and B-staged in a forced

air oven at 493K for one hour. Two sheets of BTDA + ODA film primed with LARC—2 were then assembled as in Fig. 6 and laminated as described in Example 1. The resulting laminate was clear yellow, flexible, and 100% void-free. The laminate could not be peeled.

## Claims

1. A process for laminating high temperature resistant polyimide film by:
providing at least two layers of thin polyimide film;
providing at least one layer of polyimide adhesive on one of said at least two layers of polyimide film;
assembling said two layers of polyimide film to form a sandwich and
subjecting the film-adhesive sandwich to heat and pressure to thermoplastically bond the sandwich into a void-free laminate structure,
characterized in that said polyimide adhesive layer is a solvent free polyamic acid that is B-staged to the polyimide state prior to assembling of the polyimide film sandwich.

2. The process of claim 1 wherein the polyimide adhesive is in liquid form and is brush coated on only one layer of polyimide film prior to said B-staging, or a film of polyimide adhesive is prepared and said B-staged prior to being used to bond the polyimide film.

3. The method of claim 1 wherein the polyimide film layers are selected from the group consisting of polyimides formed as the reaction product of (a) pyromellitic dianhydride (PMDA) and 4,4'-oxydianiline (ODA) and (b) benzophenone tetracarboxylic dianhydride (BTDA) and 4,4'-oxydianiline (ODA).

4. The process of claim 1 wherein a layer of conductive metal film is also provided between each two layers of polyimide film and a layer of polyimide adhesive is provided adjacent each surface of the metal film layer.

5. The process of claim 4 including:
assembling the polyimide film, metal foil and adhesive so as to give a film-adhesive-metal-adhesive-film sandwich; and
subjecting the sandwich assembly to heat and pressure to thermally bond the sandwiched assembly into a void-free laminate structure.

6. The process of claim 4 or claim 5 wherein the metal film layer is selected from the group consisting of aluminum, brass, copper and stainless steel and each member of the group being in the thickness range of 0,025 mm and 0,75 mm.

7. The process of claim 5 wherein the polyimide adhesive is applied to the laminate surfaces in liquid form and consists of a polyamic acid dissolved in a solvent or the polyimide adhesive is a thin film of a polyimide that has been previously B-staged.

8. The process of claim 1 or claim 5 wherein the polyimide adhesive is a linear polyamic acid adhesive solution selected from the group consisting of:
(a) benzophenone tetracarboxylic dianhydride (BTDA) and 3,3'-diaminobenzophenone (DABP);
(b) two parts benzophenone tetracarboxylic dianhydride (BTDA) to one part pyromellitic dianhydride (PMDA) and 3,3'-diaminobenzophenone (DABP); and
(c) three parts benzophenone tetracarboxylic dianhydride (BTDA) to one part pyromellitic dianhydride (PMDA) and 4,4'-diaminobenzophenone (DABP);
each group member being dissolved in a solvent.

9. The process of claim 8 wherein the adhesive solid concentration is approximately 15% and the solvent is selected from the group consisting on N,N-dimethylacetamide, bis(2-methoxyethyl)ether, N,N-dimethylformamide, N-methyl-2-pyrrolidone, dimethylsulfoxide, tetrahydrofuran, m-dioxane, p-dioxane and 1,2-bis(2-methoxyethoxy)ethane.

10. The process of claim 8 wherein the solvent is N,N'-dimethylacetamide and the adhesive is B-staged prior to lamination or the solvent is bis(2-methoxyethyl)ether and the adhesive is B-staged by applying a thin coat of the liquid adhesive onto a smooth surface and heating in air sufficiently to recover a thin film of polyimide adhesive.

## Patentansprüche

1. Verfahren zum Laminieren eines hochtemperaturbeständigen Polyimidfilms, bei dem man:
wenigstens zwei Schichten eines dünnen Polyimidfilms ausbildet:
wenigstens eine Schicht eines Polyimidklebers auf eine der wenigstens zwei Schichten des Polyimidfilms ausbildet;
die beiden Schichten des Polyimidfilms unter Ausbildung eines Sandwiches zusammengibt und
das Film-Kleber-Sandwich Wärme und Druck unterwirft, um eine thermoplastische Bindung des Sandwichs zu einer hohlraumfreien Laminatstruktur auszubilden,
dadurch gekennzeichnet, daß die Polyimidklebeschicht eine lösungsmittelfreie Polyamicsäure ist, die in den B-Zustand zum Polyimidzustand überführt wurde, bevor man das Polyimidfilmsandwich ausbildete.

2. Verfahren gemäß Anspruch 1, worin der Polyimidkleber in flüssiger Form vorliegt und auf nur eine Schicht des Polyimidfilms vor dem Überführen in den B-Zustand aufgebürstet wird, oder daß man einen

Film aus einem Polyimidkleber herstellt und vor der Verwendung zum Verbinden des Polyimidfilms in den B-Zustand überführt.

3. Verfahren gemäß Anspruch 1, worin die Polyimidfilmschichten ausgewählt sind aus der Gruppe bestehend aus Polyimiden, die als Reaktionsprodukte aus (a) Pyromellitdianhydrid (PMDA) und 4,4'-Oxydianilin (ODA) und (b) Benzophenontetracarbonsäuredianhydrid (BTDA) und 4,4'-Oxydianilin (ODA) gebildet wurden.

4. Verfahren gemäß Anspruch 1, worin eine Schicht aus einem leitfähigen Metallfilm auch zwischen jeweils zwei Schichten des Polyimidfilms vorgesehen ist und eine Schicht aus dem Polyimidkleber anliegend zu jeder Oberfläche der Metallfilmschicht vorgesehen ist.

5. Verfahren gemäß Anspruch 4, einschließend: Anordnen des Polyimidfilms, der Metallfolie und eines Klebers unter Ausbildung eines Film-Kleber-Metall-Kleber-Film-Sandwichs und

Einwirken von Wärme und Druck auf die Sandwichanordnung, um dadurch die Sandwichanordnung thermisch zu einer hohlraumfreien Laminatstruktur zu verbinden.

6. Verfahren gemäß Anspruch 4 oder 5, worin die Metallfilmschicht ausgewählt ist aus der Gruppe bestehend aus Aluminium, Messing, Kupfer und rostfreiem Stahl und wobei jedes glied der Gruppe in einem Dickenbereich von 0,025 mm bis 0,75 mm vorliegt.

7. Verfahren gemäß Anspruch 5, worin der Polyimidkleber auf die Laminatoberfläche in flüssiger Form aufgebracht wird und aus einer Polyamicsäure besteht, die in einem Lösungsmittel gelöst ist, oder daß der Polyimidkleber ein dünner Film aus einem Polyimid ist, das zuvor in den B-Zustand überführt wurde.

8. Verfahren gemäß Anspruch 1 oder 5, dadurch gekennzeichnet, daß der Polyimidkleber eine Klebelösung aus einer linearen Polyamicsäure, ausgewählt aus der Gruppe bestehend aus:

(a) Benzophenontetracarbonsäuredianhydrid (BTDA) und 3,3'-Diaminobenzophenon (DABP);

(b) zwei Teilen Benzophenontetracarbonsäuredianhydrid (BTDA) zu einem Teil Pyromellitsäureanhydrid (PMDA) und 3,3'-Diaminobenzophenon (DABP); und

(c) drei Teilen Benzophenontetracarbonsäuredianhydrid (BTDA) zu einem Teil Pyromellitsäuredianhydrid (PMDA) und 4,4'-Diaminobenzophenon (DABP);

wobei jedes Glied der Gruppe in einem Lösungsmittel gelöst ist, ist.

9. Verfahren gemäß Anspruch 8, worin die Feststoffkonzentration des Klebers annähernd 15% beträgt und das Lösungsmittel ausgewählt ist aus der Gruppe bestehend aus N,N-Dimethylacetamid, Bis(2-methoxyethyl)ether, N,N-Dimethylformamid, N-Methyl-2-pyrrolidon, Dimethylsulfoxid, Tetrahydrofuran, m-Dioxan, p-Dioxan und 1,2-Bis(2-methoxyethoxy)ethan.

10. Verfahren gemäß Anspruch 8, worin das Lösungsmittel N,N'-Dimethylacetamid ist und der Kleber vor dem Laminieren in den B-Zustand überführt wurde, oder das Lösungsmittel Bis(2-methoxyethyl)-ether ist und der Kleber in den B-Zustand überführt wurde, indem man eine dünne Schicht des flüssigen Klebers auf eine glatte Oberfläche aufbrachte und an der Luft ausreichend erwärmte, unter Gewinnung eines dünnen Films aus dem Polyimidkleber.

**Revendications**

1. Procédé pour la fabrication de laminés à partir de films de polyimide résistant à haute température selon lequel:

on emploie au moins deux couches de film mince de polyimide;

on emploie au moins une couche d'un adhésif polyimide sur l'une au moins de ces deux couches de film de polyimide;

on assemble ces deux couches de film de polyimide pour constituer un sandwich et

on soumet le sandwich film-adhésif à la chaleur et à la pression afin de réaliser une liaison thermoplastique du sandwich en une structure feuilletée exempte de vide;

caractérisé en ce que ladite couche d'adhésif polyimide est un acide polyamique exempt de solvant qui est mis au stade B jusqu'à l'état polyimide avant l'assemblage en sandwich des films de polyimide.

2. Procédé selon la revendication 1 selon lequel l'adhésif polyimide est sous forme liquide et il est étalé à la brosse sur une couche seulement de film de polyimide avant la mise au stade B, ou un film d'adhésif polyimide est préparé et mis au stade B avant d'être utilisé pour la liaison des films de polyimide.

3. Procédé selon la revendication 1 selon lequel les couches de film de polyimide sont choisies dans le groupe composé de polyimides formés comme le produit de la réaction de: a) du dianhydride pyromellitique (PMDA) et de la 4,4'-oxydianiline (ODA) et b) du dianhydride benzophénonetétracarboxylique (BTDA) et de la 4,4'-oxydianiline (ODA).

4. Procédé selon la revendication 1 selon lequel une couche d'un film métallique conducteur est disposée aussi entre chacune des deux couches de film polyimide et une couche d'adhésif polyimide est disposée sur chaque surface de la couche de film métallique.

5. Procédé selon la revendication 4 incluant les opérations suivantes:

on assemble le film de polyimide, la feuille métallique et l'adhésif de manière à obtenir un sandwich film-adhésif-métal-adhésif-film; et

on soumet l'ensemble du sandwich à la chaleur et à la pression pour lier thermiquement l'ensemble en sandwich en une structure feuilletée exempte de vides.

6. Procédé selon la revendication 4 ou la revendication 5 selon lequel la couche de film metallique est

choisie dans le groupe composé de l'aluminium, du laiton, du cuivre et de l'acier inoxydable et chaque membre du groupe se situe dans la gamme d'épaisseurs de 0,025 mm à 0,75 mm.

7. Procédé selon la revendication 5 selon lequel l'adhésif polyimide est appliqué à la surface des feuilles sous forme liquide et il consiste en un acide polyamique dissous dans un solvant, ou l'adhésif de polyimide est un film mince d'un polyimide qui a été mis précédemment au stade B.

8. Procédé selon la revendication 1 ou la revendication 5 selon lequel l'adhésif polyimide est une solution adhésive d'acide polyamique linéaire choisie dans le groupe composé de:

a) dianhydride benzophénone-tétracarboxylique (BTDA) et 3,3'-diaminobenzophénone (DABP);

b) deux parties de dianhydride de benzophénone-tétracarboxylique (BTDA) pour une partie de dianhydride pyromellitique (PMDA) et 3,3'-diaminobenzophénone (DABP); et

c) trois parties de dianhydride benzophénone-tétracarboxylique (BTDA) pour une partie de dianhydride pyromellitique (PMDA) et 4,4'-diaminobenzophénone (DABP);

chaque membre du groupe étant en solution dans un solvant.

9. Procédé selon la revendication 8 selon lequel la concentration en adhésif solide est approximativement de 15% et le solvant est choisi dans le groupe composé de: N,N-diméthylacétamide, bis(2-méthoxyéthyl)éther, N,N-diméthylformamide, N-méthyl-2-pyrrolidone, diméthylsulfoxyde, tétrahydrofuranne, m-dioxane, p-dioxane et 1,2-bis(2-méthoxyéthoxy)éthane.

10. Procédé selon la revendication 8 selon lequel le solvant est N,N-diméthylacétamide et l'adhésif est mis au stade B avant l'assemblage des feuilles, ou le solvant est bis(2-méthoxyéthyl)éther et l'adhésif est mis au stade B par application d'une couche mince d'adhésif liquide sur une surface régulière et par chauffage à l'air suffisamment pour recouvrer un film mince d'adhésif polyimide.

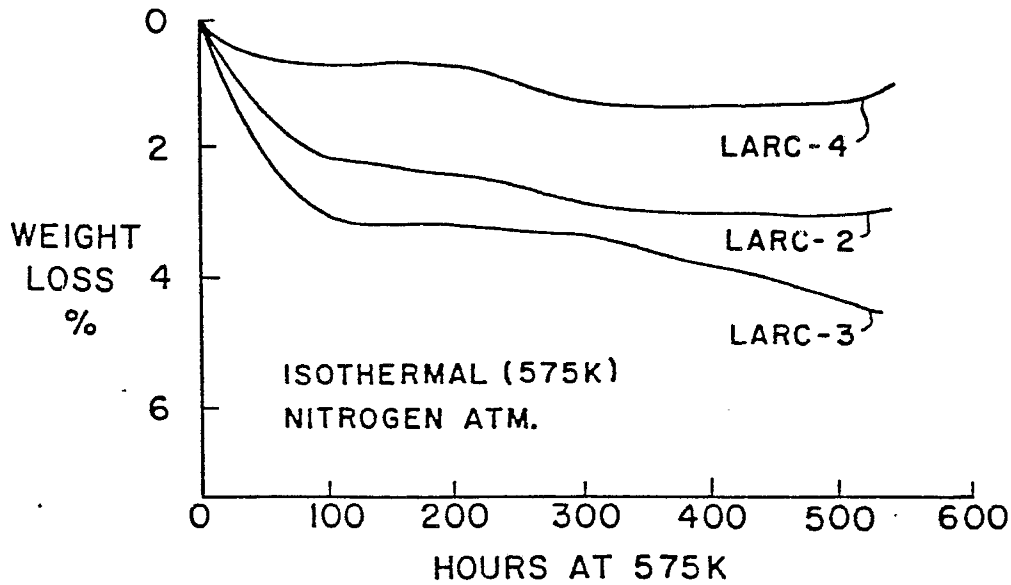


FIG. 1

FIG. 3

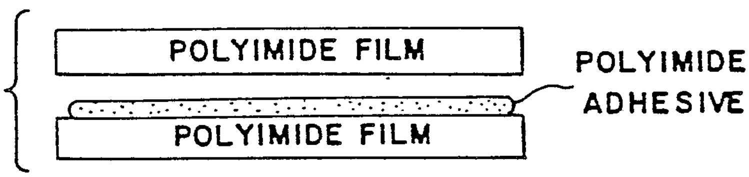


FIG. 4

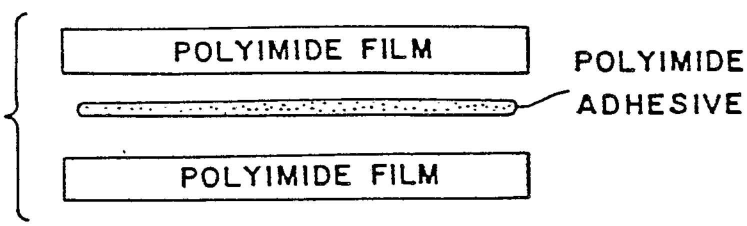


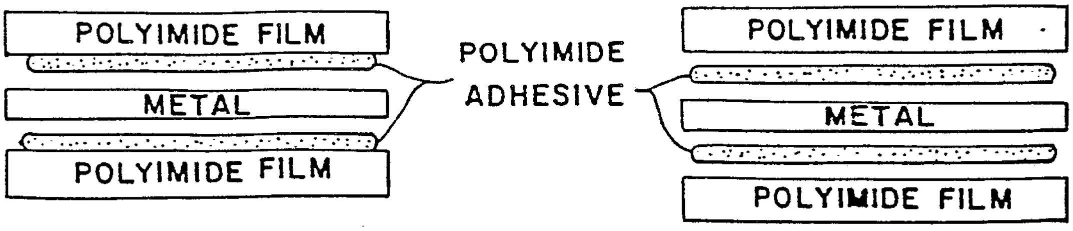


FIG. 5a

FIG. 5b

FIG. 2

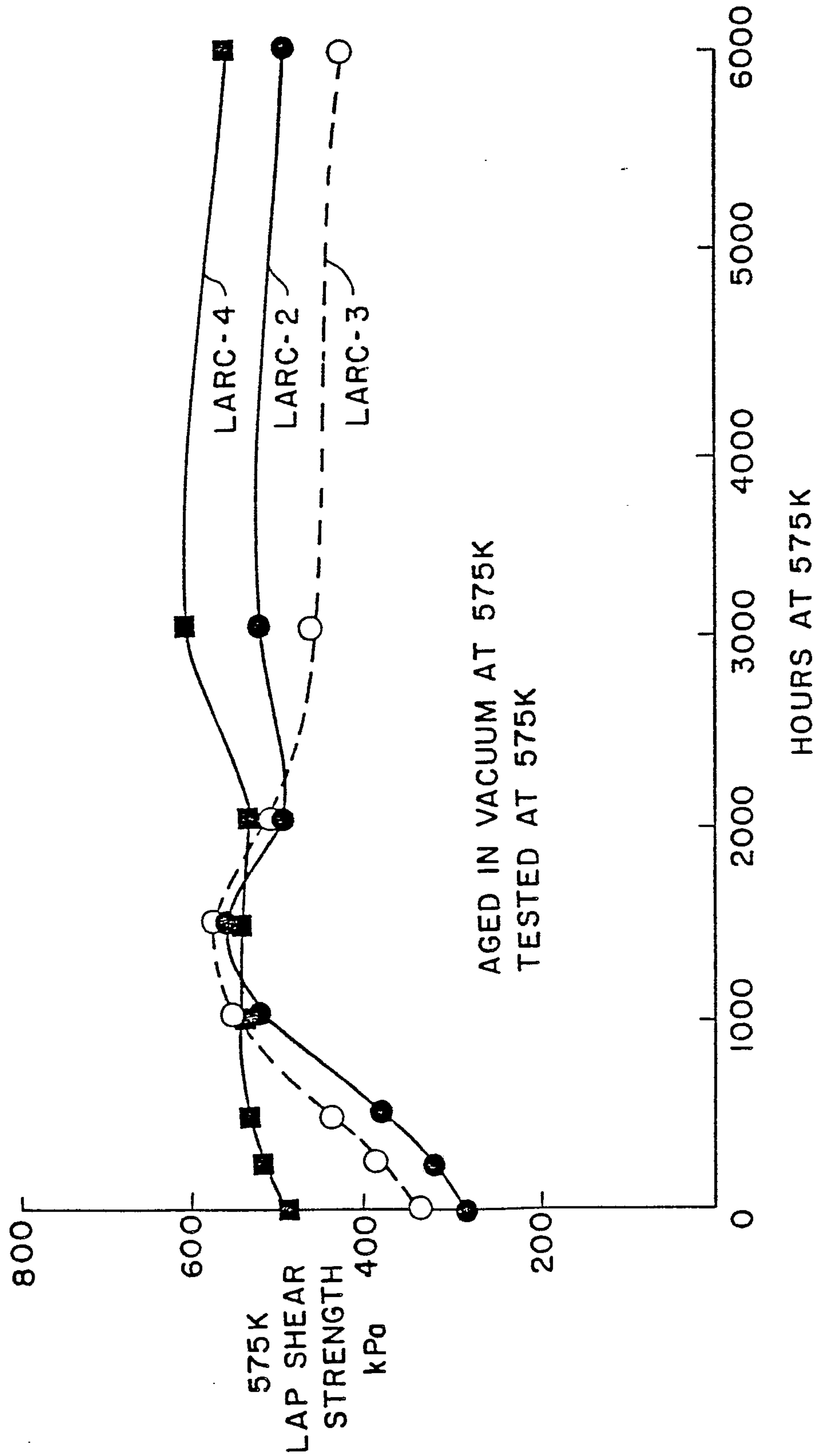
575K
LAP SHEAR
STRENGTH
kPa
800
600
400
200
0
1000
2000
3000
4000
5000
6000
HOURS AT 575K
AGED IN VACUUM AT 575K
TESTED AT 575K
LARC-4
LARC-2
LARC-3

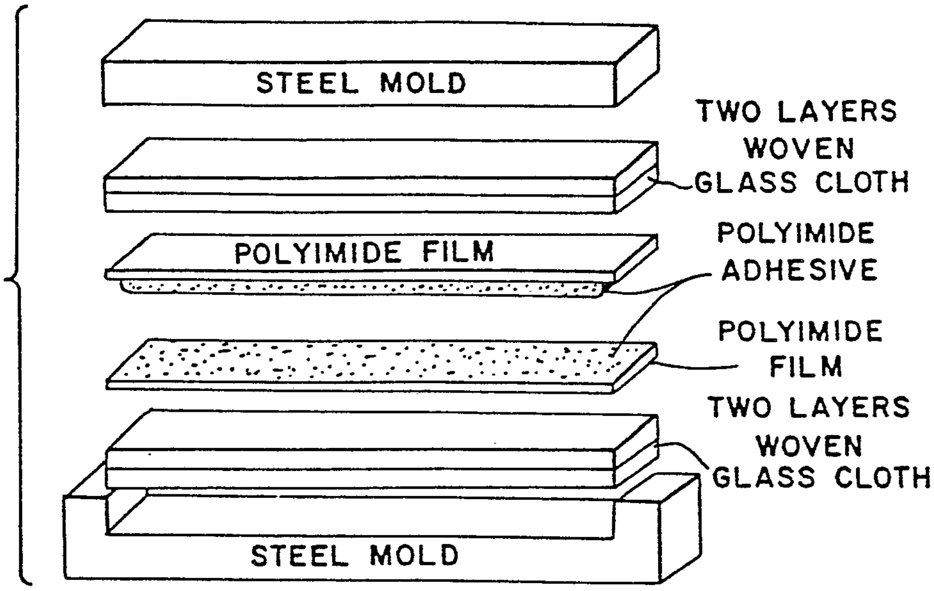
STEEL MOLD
TWO LAYERS WOVEN GLASS CLOTH
POLYIMIDE FILM
POLYIMIDE ADHESIVE
POLYIMIDE FILM
TWO LAYERS WOVEN GLASS CLOTH
STEEL MOLD

FIG. 6

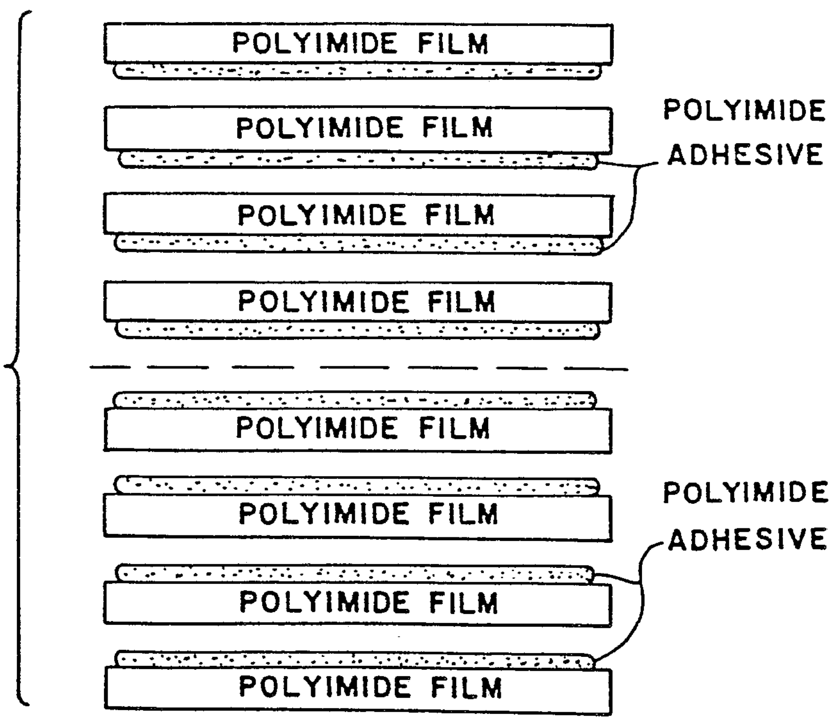
POLYIMIDE FILM
POLYIMIDE FILM
POLYIMIDE ADHESIVE
POLYIMIDE FILM
POLYIMIDE FILM
POLYIMIDE FILM
POLYIMIDE FILM
POLYIMIDE ADHESIVE
POLYIMIDE FILM
POLYIMIDE FILM

FIG. 7